# EUROPEAN PATENT SPECIFICATION

(11) **EP 3 059 771 B1**
(45) Date of publication and mention of the grant of the patent: **17.01.2018**
(21) Application number: 14892665.2
(22) Date of filing: 23.05.2014
(51) Int. Cl.: H01L 35/34, H01L 35/24

(54) **METHOD FOR MANUFACTURING A THERMOELECTRIC COOLING ELEMENT**
VERFAHREN ZUR HERSTELLUNG EINES THERMOELEKTRISCHEN KÜHLELEMENTS
PROCÉDÉ DE FABRICATION D'UN THERMOÉLÉMENT DE REFROIDISSEMENT

(43) Date of publication of application: 24.08.2016
(73) Proprietor: Otkrytoe Akcionernoe Obshchestvo "Infotek Grup", Moscow 119415 (RU)
(72) Inventor: TEREHOV, Anatoly Konstantinovich, Moskovskaya obl. g. Vidnoe 142702 (RU); RADIN, Sergei Alekseevich, Moscow 109457 (RU)
(74) Representative: Benatov, Samuil Gabriel
(86) International application number: PCT/RU2014/000371
(87) International publication number: WO 2015/178793

(56) References cited:
- EP-A1- 2 521 191
- JP-A- 2001 326 393
- US-A1- 2013 042 899
- OKAMOTO H ET AL: "Structure and properties of polyaniline films prepared via electrochemical polymerization. I: Effect of pH in electrochemical polymerization media on the primary structure and acid dissociation constant of product polyaniline films", POLYMER, ELSEVIER SCIENCE PUBLISHERS B.V, GB, vol. 39, no. 18, 1 August 1998 (1998-08-01), pages 4349-4358, XP004124548, ISSN: 0032-3861, DOI: 10.1016/S0032-3861(98)00013-5
- MOTHEO A J ET AL: "Influence of different types of acidic dopant on the electrodeposition and properties of polyaniline films", POLYMER, ELSEVIER SCIENCE PUBLISHERS B.V, GB, vol. 39, no. 26, 1 December 1998 (1998-12-01), pages 6977-6982, XP004138391, ISSN: 0032-3861, DOI: 10.1016/S0032-3861(98)00086-X

## Description

The invention refers to semiconductor technology and particularly to producing of cooling elements. The invention can be used to obtain cold for industrial, domestic and special cooling (cold storage factories, industrial air conditioners, domestic refrigerators, cooling of electronics in different devices, refrigerators).

The main task is producing of cooling element with high efficiency of refrigerating capacity relatively to contemporary analogs.

It is known semiconductive way of cooling on the base of Peltier elements. Peltier element is thermo-electric converter with operating principle of temperature difference appearance under the electric current [1]. The base of Peltier elements operation is contact of two conductive materials with different energy of electrons in conduction band. When current flows through contact of such materials electron must acquire energy for transferring to conductive band with higher energy of another semiconductor. When this energy is absorbed the contact place of these semiconductors is cooled. When current flows in reverse direction the contact place is been heated in addition to common heat effect.

Peltier effect is too negligible to be detected against resistance heating and thermal conductivity when metals are contacted. That is why contact of two semiconductors is used at practice.

Peltier element consists of one or more couples of small semiconductive boxes - one is of n-type and one is p-type in the same pair (usually bismuth telluride BiTe and silicon germanide) which are connected in pairs with metal bars. Metal bars are thermal contacts simultaneously and are been insulated with dielectric film or ceramic plate. Pairs of boxes are connected in a way that serial connection of many pairs of semiconductors with different type of conductivity is formed so one type of connection order is in upper part (n->p) and another (p->n) is in lower part. Electric current flows in series through all boxes. Depending on current direction upper contacts are been cooled and lower contacts are been heated and vice versa. Thereby electric current transfers heat from one side of Peltier element to another and provides temperature difference.

If heating side of Peltier element is being cooling with heatsink or fan then temperature of cold side becomes more below. Temperature difference can achieve about 70 K in single-stage elements depending on element type and current value.

Advantages of Peltier element are small sizes, absence of moving parts and also absence of gases and liquids. Under reversing of current direction either cooling or heating can be chosen. So thermostating is possible then ambient temperature either higher or lower than temperature to be maintained.

Disadvantages of Peltier element are very low efficiency that is accompanied with higher consuming power to achieve visible temperature difference.

US2013042899 A1 discloses a method of manufacturing an all-organic thermoelectric device comprising:
(a) applying a first subset of a plurality of pairs of semiconducting members onto a first substrate in a first pattern such that said pairs in said first subset are spaced apart from each other by a first set of gaps between said pairs on said first substrate
(b) applying a second subset of said plurality of pairs of semiconducting members onto a second substrate in a second pattern such that said pairs in said second subset are spaced apart from each other by a second set of gaps between said pairs on said second substrate,
   said first pattern and said second pattern are complementary to each other, such that when said first and second substrates are arranged opposite each other with said first and second subsets facing each other, electrical contacts between neighboring pairs of said first subset are established by pairs of said second subset, and electrical contacts between neighboring pairs of said second subset are established by pairs of said first subset; and
(c) assembling and bonding the first and second substrates together, with said first and second subsets of said plurality of pairs of semiconducting members facing each other.

Technical task of the present invention is to develop a way of producing of thermo-electric cooling elements with efficiency not lower than 85 %.

Essence of the claim according to this invention is that aniline doped with different chemical additives is used instead of semiconductive materials.

Polyaniline belongs to the class of conductive polymers with semiconductive properties. Injected carriers in conventional semiconductors are focused as band electrons and holes without of visible deformation of rigid three-dimensional crystal lattice. Equilibrium geometry under ionization in organic molecules is known to change greatly. Flexibility of quasi-single dimensional lattice in organic polymer leads to localization of charge injected under oxidization or reducing in the area of geometry deformation which is caused by this charge. Ion-radical connected with such local lattice deformation is called polaron and double-charged spineless ion which is obtained under its ionization is called bipolaron. In trans-polyacetylene with degraded ground state it is possible existence of solitons which are spineless single-charged ions and radicals without of charge and formation of which can be represented as a result of polarons and bipolarons decomposition. This scheme of charge doping and saving in conductive polymers is common. Besides of this it is assumed that wave functions of defects can be overlaid under the high defect's concentration with formation of soliton, polaron and bipolaron bands like overlaying of wave function (orbitals) of electrons in periodical structure (crystal, polymeric chain) leads to formation of well-known electron bands.

Polyaniline structure is dimerized i.e. elementary cell consists of two monomeric elements caused by Peierls distortion: 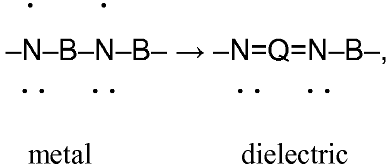 that leads to splitting of all energy bands on two. Filled and empty bands separated by a Peierls energy gap are formed from valence band. Deviation from plane molecule geometry caused by pushing off hydrogen atoms in Orto-position of adjacent rings increases this gap [2].

Proceeding from said above doped polyaniline can have properties of either p-conductor or n-conductor depending on additive and media pH.

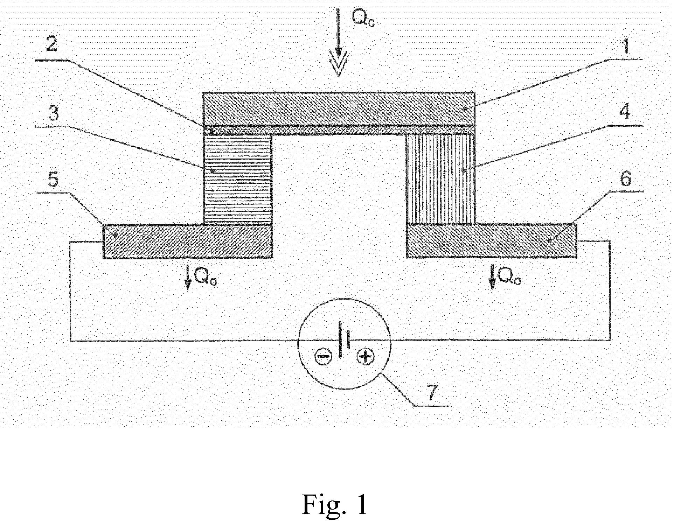

Figure 1 is a schematic view of a thermo-electric cooling element produced according to the present invention.

Making of polymeric material with p-conductivity is performed in the following way. Metal layer that can be gold, platinum or chrome is sputtered onto one side of previously flushed substrate which can be sitall, sapphire or another dielectric material. Then water solution containing hydrochloric acid with concentration 2 mol/l, aniline with concentration 0.7 mol/l and chemical additive that consists of sodium chloride with concentration 0.3 mol/l and potassium chloride with concentration 0.3 mol/l is prepared.

Then prepared solution is poured into galvanic bath. Solution temperature should be from +15 °C to +27 °C. After that prepared substrate with sputtered metal layer is dipped at one fourth of substrate surface area into the solution. Layer of sorbent which is a film of doped polyaniline is applied by method of electro-polymerization.

The process is conducted in a mode of potentiostatic cycling with potentials of working electrode that is substrate with sputtered metal layer from plus 3.3 V to minus 10.5 V relative to the counter electrode that is graphite shaft, wire or plate made of platinum, gold, nickel, stainless steel or chrome. During the process the polymer growth occurs at the place of surface of sputtered metal layer that is covered by the solution. Time of electro-polymerization process is determined individually in each case depending on thickness of needed layer for a specific task. Then substrate with doped conductive polymer is flushed with distilled water and dried.

Making of polymeric material with n-conductivity is performed in the following way. The same substrate, which has been covered already with a layer of conductive polymer with p-conductivity, after drying is dipped again from another side of metal surface in the galvanic bath with a new solution at one fourth of its surface area in a such way that layer which had been applied during previous stage does not touch the surface of the solution and should be a gap of sputtered material without of polymeric coating between surface of the solution and the border of applied polymeric layer with p-conductivity. Water solution for making of polymeric material with n-conductivity contains hydrochloric acid with concentration 2 mol/l, aniline with concentration 0.4 mol/l and chemical additive that is heteropolyacid with Keggin structure having chemical formula H₃PW₁₂O₄₀ with concentration 0.2 mol/l.

Then in a such way as it was during making of polymeric material with p-conductivity the process is conducted in the galvanic bath in a mode of the potentiostatic cycling with potentials from plus 5.2 V to minus 1.4 V at working electrode that is the same substrate with sputtered metal layer and applied polymeric layer with p-conductivity relative to the counter electrode that is graphite shaft, wire or plate made of platinum, gold or chrome. Temperature of the solution should be from +10 °C to +27 °C. Time of coating process is chosen individually as in previous making. After the process of electro-polymerization is finished conductive polymer of n-type covers one fourth of metal surface of dielectric substrate from another side and there is a gap between polymer layers where metal layer was sputtered (see Figure 1). Then substrate with doped conductive polymer is flushed with distilled water and dried.

The substrate made by such way with two layers of conductive polymers of p-type and n-type divided by gap with sputtered metal coating is a base for producing of the thermo-electric cooling element that is an analog of the Peltier element.

The thermo-electric cooling element is assembled in a following way. Two separated contact electrodes 5 and 6 are put onto layers of conductive polymers of p-type 3 and n-type 4 of made in previous technological operations plate 1 (see Figure 1) with sputtered metal coating 2 and coatings of conductive polymers layers with p- and n-conductivity on both sides. Contact electrodes 5 and 6 can be made as metal plates made of chrome, nickel, stainless steel, titanium, silver or copper.

Operation of such thermo-element is similar to operation of Peltier elements. This device is powered with DC power source 7 (as it is shown at figure). Substrate 1 is been cooled and contact electrodes 5 and 6 are been heated. If current direction is changed then process will proceed vice versa.

Example. Way of producing of the thermo-electric cooling element.

Making is performed in a following way. It was taken sitall substrate with dimensions 40*40*3 mm. After careful flushing in ether, sputtering of thin chrome layer was performed onto one side of sitall substrate. Then water solution containing hydrochloric acid with concentration 2 mol/l, aniline with concentration 0.7 mol/l and chemical additive that consists of sodium chloride with concentration 0.3 mol/l and potassium chloride with concentration 0.3 mol/l was prepared. Then prepared solution was poured into the galvanic bath. Temperature had been measured and it was +19 °C.

Prepared substrate with the sputtered chrome layer was dipped in the solution at one fourth of substrate surface area. Then a layer of the sorbent which is a film of doped polyaniline was applied by the method of electro-polymerization. The process was conducted in a mode of potentiostatic cycling with potentials of working electrode, which is the substrate with sputtered metal layer of chrome from plus 3.3 V to minus 10.5 V relative to the counter electrode that was graphite shaft. During the process the polymer growth occurred at the place of surface of sputtered metal layer that contacted with the solution.

Time of electro-polymerization process was 20 min. Then substrate with doped conductive polymer was flushed with distilled water and dried.

Then second operation began - making of polymeric material with n-conductivity. The same substrate which has been covered already with a layer of conductive polymer with p-conductivity after drying was dipped again from another side of metal surface in galvanic bath with a new solution at one fourth of its surface area in a such way that layer which had been applied during previous stage did not touch the surface of the solution and there was a gap of sputtered chrome without of coating between surface of the solution and the border of applied in previous stage polymeric layer.

New water solution for making of the polymeric material with n-conductivity was prepared in a such way that it contained hydrochloric acid with concentration 2 mol/l, aniline with concentration 0.4 mol/l and chemical additive that was heteropolyacid with a Keggin structure having chemical formula H₃PW₁₂O₄₀ with concentration 0.2 mol/l.

Then in a such way as it was during making of polymeric material with p-conductivity the process of electro-polymerization was conducted in galvanic bath in the mode of potentiostatic cycling with potentials from plus 5.2 V to minus 1.4 V at working electrode that was the same substrate with sputtered metal layer and applied polymeric layer with p-conductivity. Potentials were set relative to the counter electrode that was graphite shaft. Application time was 20 min. Temperature of the solution was maintained from +20 °C to +22 °C. Then process of electro-polymerization was finished conductive polymer of n-type had covered another one fourth part of sitall substrate on metal chrome surface, and a gap uncovered by polymer was obtained between layers of polymer (see figure). Then the substrate was flushed with distilled water and dried. After that two separate contact electrodes made of chrome plates were put onto substrate with sputtered metal chrome coating and coating from both sides with layers of conductive polymers of p- and n-conductivity which had been made in previous technological stages (see Figure 1). After that assembled device was connected to the power source as it is shown on the figure.

Power source voltage was set as 5.2 V. Current value under this voltage was 0.052 A. Ambient temperature was +24 °C. Temperature of the substrate became -4 °C after 5 minutes of current applying. When values had been stabilized a heat source with temperature +36 °C was brought to the cooling substrate. Temperature of cooling substrate increased up to -1 °C and current value increased up to 0.078 A. Electric power of thermo-electric cooling element originally was 0.27 W and became 0.45 W after the heating load had been increased.

For comparing of efficiency with a standard semiconductive Peltier element it was taken thermo-electric cooling element made by company "KRIOTERM" [3] with the same dimensions and similar experiment was performed. Power source voltage was set as 2.2 V, current value under this voltage was 0.88 A. Ambient temperature was also +24 °C and temperature of cooling surface became -4 °C. When a heat source with temperature +36 °C was applied onto the cooling surface of the Peltier element, voltage of the power source had to be increased up to 4.2 V to provide stable operation of the element. Under these conditions the current value increased up to 1.75 A. Temperature of cooling substrate also increased up to -1 °C. Electric power of the Peltier element originally was 1.94 W and became 7.35 W after the heating load had been increased.

Conclusion. Suggested way of producing of thermo-electric cooling element in this invention opens possibility to produce cooling elements with efficiency 7-16 times higher than contemporary analogs have.

### Information sources

1. Wikipedia - the free encyclopedia. Peltier Effect, https://en.wikipedia.org/wiki/Thermoelectric_effect#Peltier_effect.
2. Electrochemistry of polymers/ M.P. Tarasevich, S.B. Orlov, N.I. Shkolnikov and others, Moscow: Science, 1990, pages 121-145.
3. Company "KRIOTERM", Thermo-electric cooling modules, http://shop.kryotherm.ru/mdex.php?idCat=1.

## Claims

1. Manufacturing of a thermo-electric cooling element which includes using of semiconductive materials with p- and n-conductivity and with using of a dielectric substrate with sputtered metallic coating **characterized in that** the dielectric substrate can be made of sitall, sapphire or another dielectric material and a thin layer of metal which can be gold, platinum or chrome is to be sputtered on one side of the substrate and it is used as a working electrode on which conductive layers of doped polymer with p- and n-conductivity are applied at one fourth of its one side area and at one fourth of its another side area,
- water solution containing hydrochloric acid with concentration 2 mol/l, aniline with concentration 0.7 mol/l and chemical additive consisted of sodium chloride with concentration 0.3 mol/l and potassium chloride with concentration 0.3 mol/l is used for making of polymeric material with p-conductivity,
- then obtained solution with temperature from +15 °C to +27 °C is poured into a galvanic bath and
- after this the made substrate with sputtered metal layer is dipped into the solution at one fourth of its surface area and then sorbent layer, which is a film of doped polyaniline, is applied with electro-polymerization way, this process is conducted in a mode of potentiostatic cycling with potentials of working electrode, which is the substrate with sputtered metal layer from plus 3.3 V to minus 10.5 V relative to the counter electrode that is graphite shaft, wire or plate made of platinum, gold, nickel, stainless steel or chrome and polymer obtaining at the place of sputtered metal layer that contacts the solution during the process is occurred,
- then substrate with doped conductive polymer is flushed with distilled water and dried and then preparation of polymeric material with n-conductivity begins, for this purposes the same substrate, which has been covered already with layer of conductive polymer with p-conductivity, after drying is dipped again from another side into the galvanic bath with a new solution at one fourth of its surface area in a such way that layer which had been applied during previous stage does not touch the surface of the new solution and should be a gap of sputtered material without of polymeric coating between surface of the new solution and the border of applied polymeric layer with p-conductivity,
- water solution for making of polymeric material with n-conductivity contains hydrochloric acid with concentration 2 mol/l, aniline with concentration 0.4 mol/l and chemical additive that is heteropolyacid with a Keggin structure having chemical formula H₃PW₁₂O₄₀ with concentration 0.2 mol/l,
- then process is conducted in the galvanic bath in a mode of potentiostatic cycling with potentials from plus 5.2 V to minus 1.4 V at working electrode that is the same substrate with the sputtered metal layer and applied polymeric layer with p-conductivity relative to the counter electrode that is graphite shaft, wire or plate made of platinum, gold or chrome, temperature of the solution should be from +10 °C to +27 °C,
- after the process of electro-polymerization is finished the conductive polymer of n-type covers one fourth of dielectric substrate area from another side and there is a gap between polymer layers where the metal layer was sputtered, then substrate with doped conductive polymer is flushed with distilled water and dried,
- then the thermo-electric cooling element is directly assembled and namely two separated contact electrodes (5) and (6), which can be metal plates made of chrome, nickel, stainless steel, titanium, silver or copper, are put onto the conductive polymers layers with p-conductivity (3) and n-conductivity (4) of the pre-manufactured plate (1) with sputtered metal coating (2) and coatings of conductive polymers layers with p- and n-conductivity on both sides.

## Patentansprüche

1. Herstellung eines thermoelektrischen Kühlelements, welches die Verwendung von Halbleitermaterialien mit p- und n-Leitfähigkeit und die Verwendung eines dielektrischen Substrats mit gesputterter metallischen Beschichtung umfasst, **dadurch gekennzeichnet, dass** das dielektrische Substrat aus Sitall, Saphir oder einem anderen dielektrischen Material hergestellt sein kann und auf einer Seite des Substrats eine dünne Metallschicht, die Gold, Platin oder Chrom sein kann, gesputtert ist und welches als Arbeitselektrode verwendet wird, an deren einem Viertel seines einen Seitenbereichs und an einem Viertel seines anderen Seitenbereichs leitende Schichten aus dotiertem Polymer mit p- und n-Leitfähigkeit angebracht sind,
- Wasserlösung, die Salzsäure mit einer Konzentration von 2 mol/l, Anilin mit einer Konzentration von 0,7 mol/l und chemischen Additiv aus Natriumchlorid mit einer Konzentration von 0,3 mol/l und Kaliumchlorid mit einer Konzentration von 0,3 mol/l zur Herstellung von polymerem Material mit p-Leitfähigkeit enthält,
- die so erhaltene Lösung wird in ein galvanisches Bad mit einer Temperatur von +15° C bis +27° C gegossen und
- danach wird das hergestellte Substrat mit der gesputterten Metallschicht in die Lösung in einem Viertel seiner Oberfläche eingetaucht, und dann wird die Sorbensschicht, die eine Folie aus dotiertem Polyanilin ist, auf elektrochemische Weise aufgebracht, wobei dieses Verfahren in der Art und Weise der potentiostatischen Zyklen durchgeführt wird mit Potentialen der Arbeitselektrode, die das Substrat mit der gesputterten Metallschicht ist, von plus 3,3 V bis minus 10,5 V relativ zu der Gegenelektrode, die Graphitstange, Draht oder Platte aus Platin, Gold, Nickel, rostfreiem Stahl oder Chrom ist und während des Prozesses Polymer erhalten wird, das an der Stelle entsteht, wo die gesputterte Metallschicht mit der Lösung in Kontakt kommt,
- dann wird das Substrat mit dem dotierten leitfähigen Polymeren mit destilliertem Wasser gespült und getrocknet und dann beginnt die Herstellung von Polymermaterial mit n-Leitfähigkeit, zu diesem Zweck das gleiche Substrat, das bereits mit einer Schicht aus leitfähigem Polymer mit p-Leitfähigkeit beschichtet worden ist, wird nach dem Trocknen von einer anderen Seite wieder in das galvanische Bad mit einer neuen Lösung eingetaucht, auf einem Viertel seiner Oberfläche so dass die Schicht, die während der vorhergehenden Stufe aufgebracht wurde, die Oberfläche der neuen Lösung nicht berührt und eine Spaltstelle von gesputterten Material ohne polymere Beschichtung zwischen der Oberfläche der neuen Lösung und der Grenze der aufgebrachten Polymerschicht mit p-Leitfähigkeit bleibt,
- die Wasserlösung zur Herstellung von Polymermaterial mit n-Leitfähigkeit enthält Salzsäure mit einer Konzentration von 2 mol/l, Anilin mit einer Konzentration von 0,4 mol/l und chemisches Additiv, das eine Heteropolysäure mit einer Keggin-Struktur mit der chemischen Formel H₃PW₁₂O₄₀ mit einer Konzentration von 0,2 mol/l.
- Dann wird das Verfahren im galvanischen Bad in der Art und Weise der potentiostatischen Zyklen durchgeführt mit Potentialen von plus 5,2 V bis minus 1,4 V an der Arbeitselektrode, die dasselbe Substrat mit der gesputterten Metallschicht und der aufgebrachten Polymerschicht mit p-Leitfähigkeit ist, relativ zu der Gegenelektrode, die Graphitstange, Draht oder Platte aus Platin, Gold, oder Chrom ist, die Temperatur der Lösung sollte zwischen +10° C und +27° C liegen,
- nachdem der Prozess der Elektropolymerisation beendet ist, deckt das leitende Polymer vom n-Typ ein Viertel des dielektrischen Substratbereichs von einer anderen Seite ab und es gibt eine Lücke zwischen den Polymerschichten, wo die Metallschicht gesputtert wurde, dann wird das Substrat mit dem dotierten leitfähigen Polymer mit destilliertem Wasser gespült und getrocknet,
- dann wird das thermoelektrische Kühlelement direkt montiert und zwar zwei getrennte Kontaktelektroden (5) und (6), bei denen es sich um Metallplatten aus Chrom, Nickel, Edelstahl, Titan, Silber oder Kupfer handeln kann, auf den Polymerschichten mit p-Leitfähigkeit (3) und n-Leitfähigkeit (4) der vorgefertigten Platte (1) mit gesputterter Metallbeschichtung (2) und beidseitiger Beschichtung von leitfähigen Polymerschichten mit p- und n-Leitfähigkeit angelegt sind.

## Revendications

1. Fabrication d'un élément de refroidissement thermoélectrique qui comprend l'utilisation d'un matériau semi-conducteur avec une conductivité P-/N- et l'utilisation d'un substrat diélectrique avec un revêtement métallique pulvérisé, **caractérisé en ce que** le substrat diélectrique peut être réalisé en Sitall, en saphir ou en un autre matériau diélectrique, une mince couche de métal qui peut être de l'or, du platine ou du chrome devant être pulvérisée sur un côté du substrat et être utilisée comme une électrode de travail sur laquelle des couches conductrices de polymère renforcé avec une conductivité P-/N- sont appliquées sur un quart de l'une de ses surfaces latérales et sur un quart de son autre surface latérale, selon laquelle :
- une solution aqueuse contenant de l'acide chlorhydrique à une concentration de 2 mol/l, de l'aniline à une concentration de 0,7 mol/l, et un additif chimique contenant du chlorure de sodium à une concentration de 0,3 mol/l et du chlorure de potassium à une concentration de 0,3 mol/l est utilisée pour réaliser le polymère de conductivité P-,
- puis la solution obtenue est versée dans un bain galvanique à une température comprise entre +15°C et +27°C,
- puis le substrat fabriqué avec la couche de métal pulvérisé est plongé dans la solution à un quart de sa surface, et ensuite une couche de sorbant, qui est un film de polyaniline renforcé, est appliquée par électro-polymérisation, ce processus étant mené en mode de cycle potentiostatique avec des potentiels de l'électrode de travail, qui est le substrat avec une couche métallique pulvérisée, de plus 3,3 V à moins 10,5 V par rapport à une contre électrode qui est une tige en graphite, un fil ou une plaque en platine, en or, en nickel, en acier inoxydable ou en chrome, le polymère obtenu à l'emplacement de la couche métallique pulvérisée étant placé en contact avec la solution pendant que le processus se produit,
- puis le substrat avec le polymère conducteur renforcé est rincé avec de l'eau distillée et ensuite séché, puis la préparation du matériau polymérique avec une conductivité N- commence, le même substrat qui a déjà été couvert d'une couche de polymère conducteur à une conductivité P- étant à cette fin de nouveau plongé après séchage à un autre de ses côtés dans le bain galvanique avec une nouvelle solution sur un quart de sa surface, de sorte que la couche qui avait été appliquée au cours de l'étape précédente ne touche pas la surface de la nouvelle solution en ménageant un espace de matériau pulvérisé sans revêtement en polymère entre la surface de la nouvelle solution et la bordure de la couche polymère avec la conductivité P- appliquée,
- la solution aqueuse pour la réalisation du matériau polymérique de conductivité N- contient de l'acide chlorhydrique avec une concentration de 2 mol/l, de l'aniline avec une concentration de 0,4 mol/l et un additif chimique qui est un hétéropolyacide avec une structure de Keggin ayant la formule chimique H₃PW₁₂O₄₀ avec une concentration de 0,2 mol/l,
- puis le processus en mode de cycle potentiostatique est réalisé dans le bain galvanique avec des potentiels de plus de 5,2 V à moins 1,4 V à l'électrode de travail, qui est le même substrat que celui avec la couche de métal pulvérisée et la couche polymérique appliquée avec la conductivité P- par rapport à la contre électrode formé de la tige en graphite, fil ou plaque faite de platine, or ou chrome, la température de la solution devant être comprise entre +10°C et 27°C,
- après l'achèvement du processus d'électro-polymérisation, le polymère conducteur de type N- couvre un quart de la surface du substrat diélectrique à l'autre côté et un espace est ménagé entre les couches de polymère où la couche de métal a été pulvérisé, puis le substrat renforcé avec le polymère conducteur renforcé est rincé avec de l'eau distillée et ensuite séché,
- puis l'élément de refroidissement thermoélectrique est directement assemblé et lesdites deux électrodes de contact séparées (5) et (6), qui peuvent être les plaques faites de chrome, de nickel, d'acier inoxydable, de titane, d'argent ou de cuivre, sont placées sur les couches de polymère conducteur de conductivité P- (3) et de conductivité N- (4) de la plaque (1) préalablement réalisée avec le revêtement (2) de métal pulvérisé et les revêtements de couches de polymère conducteur de conductivité P-/N- des deux côtés.
